# EUROPEAN PATENT SPECIFICATION

(11) **EP 3 486 010 B1**
(45) Date of publication and mention of the grant of the patent: **13.08.2025**
(21) Application number: 17382774.2
(22) Date of filing: 15.11.2017
(51) Int. Cl.: B23B 47/28, B23B 49/02, B29C 64/118, B29K 507/04, B33Y 80/00

(54) **DRILING TEMPLATE**
BOHRSCHABLONE
GABARIT DE FORAGE

(43) Date of publication of application: 22.05.2019
(73) Proprietor: Airbus Operations, S.L., 28906 Getafe (ES)
(72) Inventor: JARA ROBLEDO, Alvaro, 28906 Getafe (ES); MOYA SANZ, Elena, 28906 Getafe (ES); TORRES SALAS, Alvaro, 28906 Getafe (ES); LLORENTE GARCIA, Paloma, 28906 Getafe (ES)

(56) References cited:
- WO-A1-2016/142147
- DE-A1- 102017 200 445
- US-A1- 2016 006 123
- US-A1- 2017 106 452
- US-B1- 8 757 937
- DE LEON AL C ET AL: "High performance polymer nanocomposites for additive manufacturing applications", REACTIVE AND FUNCTIONAL POLYMERS, ELSEVIER, AMSTERDAM, NL, vol. 103, 19 April 2016 (2016-04-19), pages 141 - 155, XP029539183, ISSN: 1381-5148, DOI: 10.1016/J.REACTFUNCTPOLYM.2016.04.010

## Description

### FIELD OF THE INVENTION

The present invention relates to a smart tool. More specifically, the invention relates to a smart drilling template and its different embodiments in the industrial sector, particularly in the aeronautic and aerospace industries.

### BACKGROUND

Drilling templates are well known in the state of art in order to respect the exact position and tolerances of the drilling of a set of holes in a piece or a structure. Use of drilling template in manufacturing process of aircraft or spacecraft is quiet common for drilling for example composite or metallic adjacent parts of fuselage, in order to assemble them together with fasteners such as rivet connections. But an aircraft (or a spacecraft) is a so huge building that several drilling templates are necessary to respect the manufacturing specificity and specification of each aircraft such as the family of the aircraft, and/or the section of the aircraft, and/or the parts of the section to assemble together. Moreover, in the case of work stoppage of an aircraft family, it is difficult to reuse a drilling template already used for a previous family to a new one.

It could be relevant to find another way to use or reuse drilling templates in order to reduce the ecologic print during the aircraft or spacecraft manufacturing process and costs associated.

US 8,757,937 describes a seal for a drill template tool that can be applied by means of vacuum to a surface of a part to be drilled. The seal is described in conjunction with a drill template tool designed in a CAD program and obtained with an additive manufacturing process, i.e., US 8, 757, 937 discloses a drilling template according to the preamble of claim 1.

### SUMMARY OF THE INVENTION

In order to solve the drawbacks stated above, the present invention proposes a drilling template according to claim 1. One advantage of the invention is to allow to the drilling template to improve its mechanical resistance via the graphene properties, in order to resist and conserve its integrity when high temperatures are reached due to the friction between the drilling tool and the drilling template. Another advantage of the invention is the possibility to use the ALM (Additive Laser Manufacturing) in order to manufacture quickly any simple or complex patterns of the drilling template, according to an ad-hoc design. Another advantage of the invention is the possibility to modify the shape or restyle partially or totally the drilling template, such as the framework and/or the set of traversing orifices.

Further according to the invention, the drilling template comprises a circuit board partially or totally embedded within the rigid framework, said circuit board comprising:
- a set of sensors able to measure values respectively from the rigid framework and/or from or with respect to the structure to drill;
- a set of digital and/or analogic components able to operate respectively digital or analogic signals from the set of sensors;
- at least one IHM (Interface Human Machine) able to allow to an operator or an automaton to interact with the sensors of the said drilling template;
- at least one conductive trace able to connect the set of sensors to respectively the set of digital and/or analogic components, and the at least one IHM.

This allows to confer some smart properties to the drilling template in order to interact with the operator or the automaton by itself or from a request.

In some embodiments, polymer material is used to manufacture the drilling template 20, 30a, 30b, 30c based on PLA (Polylactic Acid) or ABS (Acrylonitrile Butadiene Styrene). One advantage of these embodiments is to allow an ecologic recycling of each part of the drilling template 20, 30a, 30b, 30c comprising PLA or ABS.

In some embodiments, the set of sensors comprises a moisture sensor in order to measure the humidity of the drilling template. One advantage of these embodiments is to easily monitor and predict the need to manufacture a new drilling template in due time before the failure of the previous one in order to avoid a potential discontinuity of manufacturing process.

In some embodiments, the set of sensors comprises sensors able to measure the temperature at the surface of the structure to drill and/or directly in said drilling template. One advantage of these embodiments is that said drilling template is able to assess by itself the temperature of the surface of the structure to drill and/or its own temperature. The drilling template is able to interact with the operator or automaton via the IHM, in order to inform him about the temperatures reached due to the friction between the drilling tool with the drilling template and/or the drilling tool and the surface of the structure to drill. This advantage will increase significantly the life expectancy of the drilling templates avoiding the need of re-manufacturing and preventing inaccuracies caused by the template deformation.

In some embodiments, the set of sensors comprises gyroscopes and/or piezoelectric materials. One advantage of these embodiments is to allow to determine easily if the position and orientation of the drilling template is the adequate one. Another advantage of this solution is also to decrease the assembly time.

In some embodiments, at least one component of the set of digital and/or analogic components are manufactured via 3D printed graphene.

In some embodiments, at least one component is a 3D printed Surface-Mount Component (SMT).

In some embodiments, the drilling template comprises a 3D printed antenna.

In some embodiments, the 3D printed antenna is a RFID (Radio Frequency Identification). One advantage with the RFID is the ability to transmit, receive and store remote data.

In some embodiments, the trace has a thermal conductivity or is able to conduct electricity.

In some embodiments, the IHM is a buzzer, and/or a display interface such as LCD or a set of led.

### BRIEF DESCRIPTION OF THE DRAWINGS

To complete the description and in order to provide for a better understanding of the invention, a set of drawings is provided. Said drawings form an integral part of the description and illustrate preferred embodiments of the invention. The drawings comprise the following figures:
- Figure 1, is a schematic representation of main elements of a 3D-printer.
- Figure 2, is a schematic representation of the drilling template according to the invention.

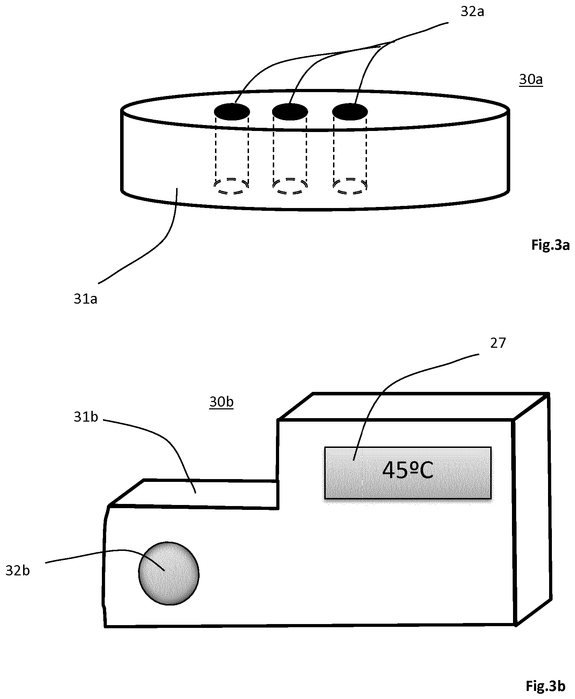

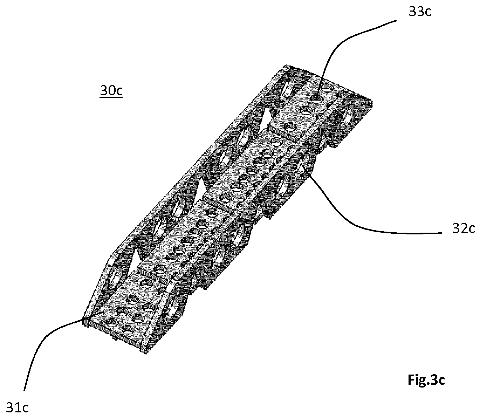

- Figures 3a-3c, are schematic representations of embodiments of a drilling template according to the invention.

### DETAILED DESCRIPTION OF THE DRAWINGS

The present invention is directed toward drilling templates.

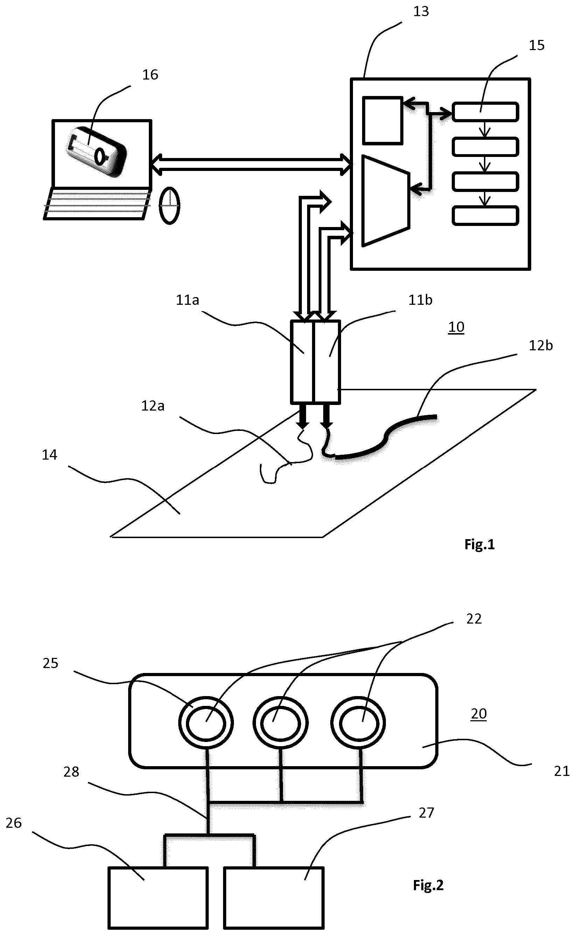

3D (Three Dimensions) printing, also known as additive layer manufacturing, is increasingly taking importance in all the different industrial sectors. There are an infinity of possible applications such as the manufacturing of tools, jigs, parts of simple or complex structure, designed according the needed. This manufacturing via 3D printing technologies is used especially with the so called Fused Deposition Modelling (FDM) as represented in figure 1.

The Fused Deposition Modelling (FDM), also called FFF (Fused Filament Fabrication) or PJP (Plastic Jet Printing) is an additive manufacturing technology. Additive manufacturing technology is commonly used for thermoplastics 3D printing with special focus on modeling, prototyping and production applications. The additive manufacturing technology is able to print 3D parts by printing 2D (Two Dimensions) continuous thickness layer, usually called 2,5D (2.5 Dimensions) as there is no coordinated movement in 3D.

The 3D printing material used to 3D print consist on a polymer base which can be PLA (Polylactic Acid) or ABS (Acrylonitrile Butadiene Styrene).

According to the invention, the polymer base is mixed with powdered graphene in order to modify some of its properties. Indeed, graphene is a nanomaterial, discovered in 2004, consisting on a one-atom-thick planar sheet of bonded carbon atoms that are densely packed in a honeycomb crystal lattice. Graphene is a basic structural element of some variants carbon such as graphite, charcoal, nanotubes, and fullerenes. Graphene has an unique electronic and mechanical properties, such as:
- a transparency and flexibility;
- a very high thermal and electrical conductivity. Indeed, graphene has a higher conductivity than Cu (copper) or Ag (silver);
- a high elasticity and hardness. Indeed, it is considered as the hardest material ever known;
- a very big lightness. Indeed, graphene is quite as light as the carbon fiber but more flexible;
- enables electrons to flow much faster than silicon.

Consequently, the addition of graphene to some material increase their potential and allow new 3D printing applications.

Furthermore, graphene opened new ways and new possibilities for the manufacturing of electronic components. Indeed, the possibility to print on sheet active or passive electronic components with graphene, such as semi-conductors, dielectric-interfaces, transistors, integrated circuits, OLED displays, or organic photovoltaic cells.

Following the different knowledge previously cited, time is come to develop a smart device or tool with the 3D printing technlogy.

In order to go on this way, according to Figure 1, the 3D-printer 10 able to 3D-print a drilling template according the invention, comprises at least a first 3D-printing head **11a** to selectively discharge conductive 3D-printing material **12a** and a second 3D-printing head **11b** to selectively discharge insulating 3D-printing material **12b**. The 3D printer **10** comprises also a processor **13** able to control the operations of the first and second 3D-printing heads **11a, 11b.** The processor **13** of the 3D-printer **10** is able to decrypt the list of steps **15** from a CAD (Computer-Aided Design) scheme **16** describing a multi-layer printed circuit board (PCB) intended for 3D-printing.

Each 3D printing head **11a, 11b** is able to print in X and Y directions for each layer of conductive or insulating 3D-printing material, such as the 3D print heads **11a, 11b** or a print bed **14** move before the following layer is printed.

In this kind of technology, the thermoplastic material filament **12a, 12b** or wire is heated pass its glass transition temperature of the material and then laid on the print bed **14** or table, where it cools down and consolidates with previous layers in order to create a solid part.

The first and second 3D-printing heads **11a, 11b** are able to 3D-print a functional passive and/or active electrical component, a functional resistor, a functional capacitor, a functional electromagnetic waveguide, a functional optical waveguide, a functional antenna or protruding antenna or horn antenna, a functional heat sink, a functional coaxial element or coaxial cable or coaxial mesh, a SMT/COB component, or equivalent. By COB component, we understand a Chip-On-Board component assembly.

The first and the second 3D-printing heads **11a, 11b** are able to 3D-print, in a same 3D printing session, a PCB (Printed Circuit Board) and an electrical component embedded within said PCB.

The first 3D printing heads **11a** that is able to discharge the conductive 3D-printing material is associated with at least a first and a second 3D-printing nozzles (not referenced on the figures). The first 3D-printing nozzle is able to discharge the conductive 3D-printing material through a first nozzle aperture having a first diameter. The second 3D-printing nozzles is able to discharge the conductive 3D-printing material through a second nozzle aperture having a second, different, diameter. In order to switch between the at least first and second 3D printing nozzle, the 3D-printer **10** comprises a switching module to selectively activate during a 3D-print process, one of the first and second 3D-printing nozzles.

In order to be more efficient, the 3D printer **10** requires some additional modules. These modules are describes below and can be use alone or in combination with others in order to reach the goal expected. This following list of embodiment of additional modules is not exhaustive and can be completed according the specific needs and the technological advances in the 3D-printer field.

In some embodiments, the 3D-printer **10** comprises an ultraviolet (UV) energy based curing module, to emit ultraviolet radiation for curing 3D-printed materials region-by-region when the 3D-printed materials are being 3D-printed.

In some embodiments, the 3D-printer **10** comprises a laser source to emit a laser beam for curing 3D-printed materials region-by-region when the 3D-printed materials are being 3D-printed.

In some embodiments, the 3D-printer **10** comprises a laser source to emit a targeted laser beam for curing just-dispensed 3D-printed materials.

The 3D-printer **10** is able to proceed to a transition between two crossed conductive materials, with the following sequential 3D printing:
- a first trace of a conductive material **12a;**
- on the top of a particular spot of the first trace, a bridge formed from an insulating material **12b,**
- on the top of the bridge, a second trace of conductive material **12a.**

In some embodiments, the 3D-printer **10** comprises an Automatic Optical Inspection (AOI) module able sequentially to:
- capture an image of a 3D-printed conductive trace during an ongoing 3D-printing session;
- compare the captured image to a reference indicating a required width of the 3D-printed conductive trace;
- based on the comparison, determine that a width of at least a portion of the 3D-printed conductive trace is smaller than the required width;
- trigger a corrective 3D-printing operation to increase the width of said portion of the 3D-printed conductive trace.

In some embodiments, the 3D-printer **10** comprises an Automatic Optical Inspection (AOI) module sequentially able to:
- capture an image of 3D-printed conductive trace during an ongoing 3D-printed session;
- compare the captured image to a reference indicating a required width of the 3D-printed conductive trace;
- based on the comparison, determine that a width of at least a portion of the 3D-printed conductive trace is greater than the required width;
- to trigger a laser ablation module to decrease the width of said portion of the 3D-printed conductive trace.

In some embodiments, the 3D-printer **10** comprises an Automatic Optical Inspection (AOI) module sequentially able to :
- capture an image of 3D-printed conductive trace during an ongoing 3D-printing session;
- compare the captured image to a reference indicating a required structure of the 3D-printed conductive trace;
- based on a comparison, identify a fracture in the 3D-printed conductive trace;
- trigger a corrective 3D-printing operation to 3D-print again, correctly, at least a region comprising said fracture.

In some embodiment, the 3D-printer **10** comprises an Automatic Optical Inspection (AOI) module sequentially able to:
- capture an image of a 3D-printed pad of during an ongoing 3D-printing session of a 3D-printed PCB;
- compare the captured image to a reference indicating a required structure of the 3D-printed pad;
- based on the comparison, determine that the 3D-printedpad is excessively large;
- trigger a laser ablation module to decrease the size of said 3D-printed pad.

In some embodiments, the 3D-printer **10** comprises a sodermask 3D-printing module able to 3D-print a soldermask with conductive material **12a** on a 3D-printed PCB, wherein the soldermask and the PCB are 3D-printed in a single, unified, 3D-printing process.

In some embodiments, the 3D-printer **10** comprises a heat sink 3D-printing module to 3D-print a thermally-conductive heat sink integrated in a pre-defined region of a 3D-printed PCB being 3-printed.

In some embodiments, the 3D-printer **10** comprises a thermal conductivity planner able to:
- determine that a particular region of a PCB being 3D-printed, being located under a 3D-printed conductive pad, requires a heat transfer path with increased thermal conductivity;
- 3D-print, in a region under said 3D-printed conductive pad, with a first 3D-printing material having increased thermal conductivity relative to a second 3D-printing material used for 3D-printing at a surrounding region which does not require a heat transfer path with increased thermal conductivity.

In some embodiments, the 3D-printer **10** comprises a thermal conductivity planner able to:
- determine that a particular region of a PCB being 3D-printed requires a heat transfer path with increased thermal conductivity;
- 3D-print, at said particular region of the PCB being 3D-printed, an electrically conductive path extending from said particular region downwardly to a 3D-printed heat sink at a bottom portion of said PCB being 3D-printed.

In some embodiments, the 3D-printer **10** comprises an embedded SMT component 3D-printing module, to 3D-print a 3D-printed PCB having a fully-buried (unexposed 3D-printed Surface-Mount Technology (SMT) component .

In some embodiments, the 3D-printer **10** comprises a pause-and resume 3D-printing controller, able to:
- pause a 3D-printing process of a PCB being 3D-printed, and
- wait until a COB/SMT component is assembled onto an already-3D-printed portion of the PCB on top of the COB/SMT that was 3D-printed.

In some embodiments, the 3D-printer **10** comprises a module able to modify the trace width/thickness, during a 3D-printing process of a conductive trace, at least one of
- a width of the constructive trace being 3D-printed, and
- a thickness of the conductive trace being 3D-printed;
wherein said module is able to modify trace width/thickness of the conductive trace while maintaining a fixed current-carrying capacity of said conductive trace.

In some embodiments, the 3D-printer **10** comprises a module able to modify the rigidity and/or flexibility when said 3D-printer **10** needs to 3D-print a PCB having a gradually-changing level of rigidity.

In some embodiments, the 3D-printer **10** comprises a module able to modify the rigidity and/or flexibility when said 3D-printer **10** needs to 3D-print a PCB having an abruptly-changing level of rigidity.

In some embodiments, the 3D-printer **10** comprises a module able to modify a dielectric material thickness when said 3D-printer **10** needs to 3D-print, between a first 3D-printed conductive layer and a second, neighboring, non-parallel, 3D-printed conductive layer, a dielectric material having varying thickness.

In some embodiments, the 3D printer **10** is able to 3D-print a conductive material to create a three-dimensional structure of a first layer of a PCB and a second, non-parallel, layer of the PCB.

The 3D-printer **10** is able to 3D-print a drilling template **20, 30a, 30b, 30c** according to the invention, comprising a rigid framework able to be manipulated by an operator or an automaton. An operator is defined by a human or humanoid entitled and able to handle with his hand said drilling template. An automaton is defined by a self-operating machine, or a machine, or a control mechanism designed to automatically follow a predetermined sequence of operations, or respond to predetermined instructions. The drilling template **20, 30a, 30b, 30c** comprises a set of traversing orifices **22, 32a, 32b, 32c, 33c** designed according to the requested holes to drill. The 3D-printer **10** is able to design or restyle on an ad-hoc basis. According to the invention, the drilling template **20, 30a, 30b, 30c** is 3D-printed via a 3D-printing technology based on a polymer material mixed with powdered graphene. Consequently, one main advantage of the invention is to allow to the drilling template **20, 30a, 30b, 30c** to improve its mechanical resistance via the graphene properties, in order to resist and conserve its integrity when high temperatures are reached due to the friction between the drilling tool and the drilling template **20, 30a, 30b, 30c.** Another advantage of the invention is the possibility to use the ALM (Additive Laser Manufacturing) in order to manufacture/3D-print quickly any simple or complex patterns of drilling template **20, 30a, 30b, 30c,** according to Z an ad-hoc design. Another advantage of the invention is the possibility to modify the shape or restyle partially or totally the drilling template **20, 30a, 30b, 30c,** such as the framework and/or the set of traversing orifices **22, 32a, 32b, 32c, 33c.**

Further according to the invention, the drilling template comprises a circuit board, prefererably 3D-printed, partially or totally embedded within the rigid framework, said circuit board comprising
- a set of sensors **25,** preferably partially or totally 3D-printed, able to measure values respectively from the rigid framework and/or from or with respect to the structure to drill;
- a set of digital and/or analogic components **26,** preferably partially or totally 3D-printed, able to operate respectively digital or analogic signals from the set of sensors;
- at least one IHM (Interface Human Machine) **27,** preferably partially or totally 3D-printed, able to allow to an operator or an automaton to interact with the sensors of the said drilling template **20, 30a, 30b, 30c;**
- at least one conductive trace **28** able to connect the set of sensors to respectively the set of digital and/or analogic components, and the at least one IHM. This allows to confer some smart properties to the drilling template **20, 30a, 30b, 30c** in order to interact with the operator or automaton by itself or from a request. Indeed, the operator or the automaton are able to interact directly or indirectly with the drilling template **20, 30a, 30b, 30c** via the IHM.

In an embodiment according to the invention, polymer material is used to manufacture the drilling template 20, 30a, 30b, 30c based on PLA (Polylactic Acid) or ABS (Acrylonitrile Butadiene Styrene). One main advantage of this embodiment is to allow an ecologic recycling of each part of the drilling template 20, 30a, 30b, 30c comprising PLA or ABS.

In an embodiment according to the invention, the set of sensors **25** comprises a moisture sensor in order to measure the humidity of the drilling template **20, 30a, 30b,** 30c. One main advantage of this embodiment is to easily monitor and predict the need to manufacture/3D-print a new drilling template **20, 30a, 30b, 30c** in due time before the failure of the previous one in order to avoid a potential discontinuity during the manufacturing process.

In an embodiment according to the invention, the set of sensors **25** comprises sensors able to measure the temperature at the surface of the structure to drill and/or directly in said drilling template **20, 30a, 30b, 30c**. One main advantage of this embodiment is that said drilling template **20, 30a, 30b, 30c** is able to assess by itself the temperature of the surface of the structure to drill and/or its own temperature. The drilling template **20, 30a, 30b, 30c** is able to interact with the operator or automaton via the IHM **27,** in order to inform him/it about the temperatures reached due to the friction between the drilling tool with the drilling template **20, 30a, 30b, 30c** and/or the drilling tool and the surface of the structure to drill. The main advantage of this embodiment is the increasement significantly of the life expectancy of the drilling templates **20, 30a, 30b, 30c.** That allows to avoid the need of re-manufacturing and preventing inaccuracies caused by the template deformation.

In an embodiment according to the invention, the set of sensors **25** comprises gyroscopes and/or piezoelectric materials. One main advantage of this embodiment is to allow to determine easily if the position and orientation of the drilling template **20, 30a, 30b, 30c** is adequate or not. Another advantage of this embodiment is also to decrease the assembly time.

In an embodiment according to the invention, at least one component of the set of digital and/or analogic components **26** is manufactured via 3D-printed graphene.

In an embodiment according to the invention, at least one component **26** is a 3D printed Surface-Mount Component (SMT) or a Chip On Board (COB).

In an embodiment according to the invention, the drilling template comprises a 3D printed antenna.

In an embodiment according to the invention, the 3D printed antenna is a RFID (Radio Frequency Identification). One main advantage with the RFID antenna is the ability to transmit, receive and store remote data quickly to a humanoid or an automaton able to communicate with said drilling template **20, 30a, 30b, 30c.**

In an embodiment according to the invention, the trace **28** has a thermal conductivity or is able to conduct electricity. The 3D-printer **10** is able to add more or less graphene powder in the conductive material **12a** in order to obtain a trace **28** with a better thermal or electricity conductivity.

In an embodiment according to the invention, the IHM is a buzzer, and/or a display interface such as LCD or a set of led to interact easily the human operator.

In an embodiment according to the invention, the drilling template **20, 30a, 30b, 30c** comprises a part relative to a battery in order to feed all the consumers, such as the set of sensors **25,** the set of digital and/or analogic components **26,** and the IHM **27.** In this embodiment according to the invention, the battery is rechargeable.

From the foregoing, it will be appreciated that specific embodiments of the invention have been described herein for purposes of illustration, but that various modifications may be made without deviating from the scope of the invention.

Accordingly, the invention is not limited except as by the appended claims.

## Claims

1. - Drilling template (20, 30a, 30b, 30c) comprising :
- a rigid framework (21, 31a, 31b, 31c) able to be manipulated by an operator or an automaton, and
- a set of traversing orifices (22,32a, 32b, 32c, 33c) designed according to the requested holes to drill, wherein
- the drilling template (20, 30a, 30b, 30c) is designed or restyled on an ad-hoc basis and manufactured via a 3D printing technology based on a polymer material **characterized in that** the polymer material is mixed with powdered graphene and **in that** the drilling template comprises a circuit board partially or totally embedded within the rigid framework (21, 31a, 31b, 31c), said circuit board comprising:
- a set of sensors (25) able to measure values respectively from the rigid framework (21, 31a, 31b, 31c) and/or from or with respect to the structure to drill;
- a set of digital and/or analogic components (26) able to operate respectively digital or analogic signals from the set of sensors (25);
- at least one IHM (Interface Human Machine) (27) able to allow to an operator or an automaton to interact with the sensors (25) of the said drilling template (20, 30a, 30b, 30c); and
- at least one conductive trace (28) able to connect the set of sensors (25) to respectively the set of digital and/or analogic components (26), and the at least one IHM (27).

2. - Drilling template (20, 30a, 30b, 30c) according to claim 1, **characterized in that** the polymer material used to manufacture said drilling template (20, 30a, 30b, 30c) is based on PLA (Polylactic Acid) or ABS (Acrylonitrile Butadiene Styrene).

3. - Drilling template (20, 30a, 30b, 30c) according to claim 1 or 2, **characterized in that** the set of sensors (25) comprises a moisture sensor in order to measure the humidity of the drilling template (20, 30a, 30b, 30c).

4. - Drilling template (20, 30a, 30b, 30c) according to claim 1 to 3, **characterized in that** the set of sensors (25) comprises sensors able to measure the temperature at the surface of the structure to drill and/or directly within said drilling template (20, 30a, 30b, 30c).

5. - Drilling template (20, 30a, 30b, 30c) according to claim 1 to 4, **characterized in that** the set of sensors (25) comprises gyroscopes and/or piezoelectric materials to determine if the position and orientation of the drilling template (20, 30a, 30b, 30c) is the adequate one.

6. - Drilling template (20, 30a, 30b, 30c) according to claim 1 to 5, **characterized in that** at least one component of the set of digital and/or analogic components (26) is manufactured via 3D printed graphene.

7. **-** Drilling template (20, 30a, 30b, 30c) according to claim 6, **characterized in that** at least one component (26) is a 3D printed Surface-Mount Component (SMT).

8. - Drilling template (20, 30a, 30b, 30c) according to the previous claims, **characterized in that** the drilling template (20, 30a, 30b, 30c) comprises a 3D printed antenna.

9. - Drilling template (20, 30a, 30b, 30c) according to claim 8, **characterized in that** the 3D printed antenna is a RFID (Radio Frequency Identification).

10. - Drilling template (20, 30a, 30b, 30c) according to claims 1 to 9, **characterized in that** the trace (28) has a thermal conductivity or is able to conduct electricity.

11. - Drilling template (20, 30a, 30b, 30c) according to claims 1 to 10, **characterized in that** the IHM (27) is a buzzer, and/or a display interface such as LCD or a set of Led.

## Patentansprüche

1. Bohrschablone (20, 30a, 30b, 30c), die Folgendes umfasst:
- ein starres Rahmenwerk (21, 31a, 31b, 31c), das in der Lage ist, von einem Bediener oder einem Automaten manipuliert zu werden, und
- einen Satz von Durchgangsöffnungen (22, 32a, 32b, 32c, 33c), die entsprechend den geforderten zu bohrenden Löchern ausgestaltet sind,
wobei
- die Bohrschablone (20, 30a, 30b, 30c) auf einer Ad-hoc-Basis ausgestaltet oder neu entworfen und über eine 3D-Drucktechnologie auf Basis eines Polymermaterials hergestellt wird
**dadurch gekennzeichnet, dass** das Polymermaterial mit pulverförmigem Graphen gemischt ist, und dadurch, dass die Bohrschablone eine Leiterplatte umfasst, die teilweise oder vollständig in das starre Rahmenwerk (21, 31a, 31b, 31c) eingebettet ist, wobei die Leiterplatte Folgendes umfasst:
- einen Satz von Sensoren (25), die in der Lage sind, Werte jeweils von dem starren Rahmenwerk (21, 31a, 31b, 31c) und/oder von oder in Bezug auf die zu bohrende Struktur zu messen;
- einen Satz digitaler und/oder analoger Komponenten (26), die in der Lage sind, jeweils digitale oder analoge Signale von dem Satz von Sensoren (25) zu handhaben;
- mindestens eine IHM (Schnittstelle Mensch-Maschine) (27), die in der Lage ist, einem Bediener oder einem Automaten zu ermöglichen, mit den Sensoren (25) der Bohrschablone (20, 30a, 30b, 30c) zu interagieren; und
- mindestens eine Leiterbahn (28), die in der Lage ist, den Satz von Sensoren (25) mit jeweils dem Satz von digitalen und/oder analogen Komponenten (26) und der mindestens einen IHM (27) zu verbinden.

2. Bohrschablone (20, 30a, 30b, 30c) nach Anspruch 1, **dadurch gekennzeichnet, dass** das zur Herstellung der Bohrschablone (20, 30a, 30b, 30c) verwendete Polymermaterial auf PLA (Polymilchsäure) oder ABS (Acrylnitril-Butadien-Styrol) basiert.

3. Bohrschablone (20, 30a, 30b, 30c) nach Anspruch 1 oder 2, **dadurch gekennzeichnet, dass** der Satz von Sensoren (25) einen Feuchtigkeitssensor umfasst, um die Feuchtigkeit der Bohrschablone (20, 30a, 30b, 30c) zu messen.

4. Bohrschablone (20, 30a, 30b, 30c) nach Anspruch 1 bis 3, **dadurch gekennzeichnet, dass** der Satz von Sensoren (25) Sensoren umfasst, die in der Lage sind, die Temperatur an der Oberfläche der zu bohrenden Struktur und/oder direkt innerhalb der Bohrschablone (20, 30a, 30b, 30c) zu messen.

5. Bohrschablone (20, 30a, 30b, 30c) nach Anspruch 1 bis 4, **dadurch gekennzeichnet, dass** der Satz von Sensoren (25) Gyroskope und/oder piezoelektrische Materialien umfasst, um zu bestimmen, ob die Position und Ausrichtung der Bohrschablone (20, 30a, 30b, 30c) die geeignete ist.

6. Bohrschablone (20, 30a, 30b, 30c) nach Anspruch 1 bis 5, **dadurch gekennzeichnet, dass** mindestens eine Komponente des Satzes von digitalen und/oder analogen Komponenten (26) über 3D-gedrucktes Graphen hergestellt ist.

7. Bohrschablone (20, 30a, 30b, 30c) nach Anspruch 6, **dadurch gekennzeichnet, dass** mindestens eine Komponente (26) eine 3D-gedruckte oberflächenmontierte Komponente (SMT) ist.

8. Bohrschablone (20, 30a, 30b, 30c) nach den vorhergehenden Ansprüchen, **dadurch gekennzeichnet, dass** die Bohrschablone (20, 30a, 30b, 30c) eine 3D-gedruckte Antenne umfasst.

9. Bohrschablone (20, 30a, 30b, 30c) nach Anspruch 8, **dadurch gekennzeichnet, dass** die 3D-gedruckte Antenne eine RFID (Radiofrequenz-Identifikation) ist.

10. Bohrschablone (20, 30a, 30b, 30c) nach den Ansprüchen 1 bis 9, **dadurch gekennzeichnet, dass** die Bahn (28) eine Wärmeleitfähigkeit aufweist oder in der Lage ist, elektrisch zu leiten.

11. Bohrschablone (20, 30a, 30b, 30c) nach den Ansprüchen 1 bis 10, **dadurch gekennzeichnet, dass** die IHM (27) ein Summer und/oder eine Anzeigeschnittstelle, wie etwa LCD oder ein LED-Satz, ist.

## Revendications

1. Gabarit de forage (20, 30a, 30b, 30c) comprenant :
- un cadre rigide (21, 31a, 31b, 31c) apte à être manipulé par un opérateur ou un automate, et
- un ensemble d'orifices traversants (22, 32a, 32b, 32c, 33c) conçus en fonction des trous pour lesquels un forage est requis,
dans lequel
- le gabarit de forage (20, 30a, 30b, 30c) est conçu ou redessiné sur une base ad-hoc et fabriqué par l'intermédiaire d'une technologie d'impression 3D à base d'un matériau polymère
**caractérisé en ce que** le matériau polymère est mélangé avec du graphène en poudre et **en ce que** le gabarit de forage comprend une carte de circuit imprimé partiellement ou totalement intégrée à l'intérieur du cadre rigide (21, 31a, 31b, 31c), ladite carte de circuit imprimé comprenant :
- un ensemble de capteurs (25) aptes à mesurer des valeurs respectivement à partir du cadre rigide (21, 31a, 31b, 31c) et/ou à partir de ou par rapport à la structure à forer ;
- un ensemble de composantes numériques et/ou analogiques (26) aptes à exploiter respectivement des signaux numériques ou analogiques provenant de l'ensemble de capteurs (25) ;
- au moins une IHM (Interface Human Machine) (27) apte à permettre à un opérateur ou un automate d'interagir avec les capteurs (25) dudit gabarit de forage (20, 30a, 30b, 30c) ; et
- au moins une trace conductrice (28) apte à connecter l'ensemble de capteurs (25) respectivement à l'ensemble des composants numériques et/ou analogiques (26), et à l'au moins une IHM (27).

2. Gabarit de forage (20, 30a, 30b, 30c) selon la revendication 1, **caractérisé en ce que** le matériau polymère utilisé pour fabriquer ledit gabarit de forage (20, 30a, 30b, 30c) est à base de PLA (acide polylactique) ou d'ABS (acrylonitrile butadiène styrène).

3. Gabarit de forage (20, 30a, 30b, 30c) selon la revendication 1 ou la revendication 2, **caractérisé en ce que** l'ensemble de capteurs (25) comprend un capteur d'humidité pour mesurer l'humidité du gabarit de forage (20, 30a, 30b, 30c).

4. Gabarit de forage (20, 30a, 30b, 30c) selon les revendications 1 à 3, **caractérisé en ce que** l'ensemble de capteurs (25) comprend des capteurs aptes à mesurer la température au niveau de la surface de la structure pour forer et/ou directement à l'intérieur dudit gabarit de forage (20, 30a, 30b, 30c).

5. Gabarit de forage (20, 30a, 30b, 30c) selon les revendications 1 à 4, **caractérisé en ce que** l'ensemble de capteurs (25) comprend des gyroscopes et/ou des matériaux piézoélectriques pour déterminer si la position et l'orientation du gabarit de forage (20, 30a, 30b, 30c) sont adéquates.

6. Gabarit de forage (20, 30a, 30b, 30c) selon les revendications 1 à 5, **caractérisé en ce qu'**au moins un composant de l'ensemble des composants numériques et/ou analogiques (26) est fabriqué par l'intermédiaire de graphène imprimé en 3D.

7. Gabarit de forage (20, 30a, 30b, 30c) selon la revendication 6, **caractérisé en ce qu'**au moins un composant (26) est un composant de montage en surface imprimé en 3D (SMT).

8. Gabarit de forage (20, 30a, 30b, 30c) selon les revendications précédentes, **caractérisé en ce que** le gabarit de forage (20, 30a, 30b, 30c) comprend une antenne imprimée en 3D.

9. Gabarit de forage (20, 30a, 30b, 30c) selon la revendication 8, **caractérisé en ce que** l'antenne imprimée 3D est une RFID (identification par radiofréquence).

10. Gabarit de forage (20, 30a, 30b, 30c) selon les revendications 1 à 9, **caractérisé en ce que** la trace (28) a une conductivité thermique ou est apte à conduire de l'électricité.

11. Gabarit de forage (20, 30a, 30b, 30c) selon les revendications 1 à 10, **caractérisé en ce que** l'IHM (27) est un buzzer, et/ou une interface d'affichage telle que LCD ou un ensemble de Led.
